Europäisches Patentamt
European Patent Office
Office européen des brevets

(11) Publication number: 0 275 891 A2

# EUROPEAN PATENT APPLICATION

(21) Application number: 88100271.1

(22) Date of filing: 12.01.88

(51) Int. Cl.⁴: H05K 3/38 , C09J 3/00

(30) Priority: 14.01.87 US 281

(43) Date of publication of application: 27.07.88 Bulletin 88/30

(84) Designated Contracting States: CH FR GB IT LI NL SE

(71) Applicant: KOLLMORGEN CORPORATION
10 Mill Pond Lane
Simsbury, CT 06070(US)

(72) Inventor: Kohm, Thomas S.
5, Target Rock Road
Huntington, NY 11743(US)

(74) Representative: Königseder, geb. Egerer, Claudia
Zugspitzstrasse 65
D-8104 Grainau(DE)

## (54) Bonding compositions for the manufacture of additive printed wiring boards & articles made with the bonding composition.

(57) This invention concerns a bonding composition useful for the manufacture of fully and semi-additive printed wiring boards. The composition comprises a phenolic resin substantially free of methyl ether groups with an average of four to ten phenolic rings per molecule and at least two methylol functional groups; at least one heat resistant polymer with an aromatic or cyclic backbone and functional groups capble of crosslinking with the phenolic methylol groups without evolving water and present in an amount sufficient to react with the methylol groups; and 30 to 60% by weight of an elastomer. The composition is applied and cured on a printed wiring base material. After curing, the composition is capable of being adhesion promoted for adherent electroless metal deposition. The bonding composition is capable of maintaining the bond of the deposited metal for 10 seconds during repair cycles with a soldering iron at 430°C.

EP 0 275 891 A2

# BONDING COMPOSITIONS FOR THE MANUFACTURE OF ADDITIVE PRINTED WIRING BOARDS AND ARTICLES MADE WITH THE BONDING COMPOSITION

This invention relates to improved bonding compositions, articles and printed wiring boards manufactured employing the improved bonding compositions. The bonding compositions are characterized by high bond strength at elevated temperatures. and the additive printed wiring boards incorporating the bonding composition are characterized in that they are highly resistant to damage when heated to unsolder and remove defective components.

Printed wiring boards consist of a copper conductive pattern bonded to an insulating plastic substrate. The conductive pattern may be bonded to the substrate either by means of an intermediate adhesive layer. or by the polymer resin of the plastic substrate. Electronic components are mounted on the printed wiring board and soldered in place. Soldering temperatures are 250 to 290°C, and severely stress the bond between the conductive pattern and the base material. When a component is defective or improperly positioned, it must be unsoldered and removed. In such cases, the bond is stressed not only thermally, but also mechanically by the force required to remove the component. The failure during repair of the bond between the conductive pattern and the base material has been a problem with additive printed wiring boards, and has required repair workers to develop special techniques to avoid damaging the printed wiring board.

Manufacturers of additive printed wiring boards have attempted to alleviate these repair problems by quality control, such as monitoring the adhesive bond at elevated temperatures. The bond of the conductive pattern to the base material is measured by a peel strength test. At room temperature a typical specification requires a minimum peel strength of 1.4 N/mm.

However, at 260°C, the peel strength of the conductive pattern on a printed wiring board may drop as low as 0.2 N/mm or below.

Adhesives used for additive printed wiring boards are alloys of thermosetting resins and elastomers. The polymers in the most commonly used adhesives are blends of approximately 55% nitrile rubber and 45% phenol-formaldehyde resins. These rubber-resin blends are usually reinforced with fillers and contain minor amounts of epoxy resins, other elastomers and curing agents.

In most manufacturing processes for additive printed wiring boards, the adhesive is applied to the insulating base material and hardened or cured. The cured adhesive is a diphase system with a rubber rich phase dispersed in a resin rich matrix. The cured diphase adhesive surface is oxidized with chromic acid, permanganate or a plasma. The oxidation of the cured adhesive surface adhesion promotes it by creating micropores and making the surface hydrophilic. The adhesion promoted surface is plated with electrolessly deposited copper to create the conductive pattern of the printed wiring board. After the plating operating, the printed wiring board is baked at 160°C to drive off moisture and any other volatiles absorbed by the base material during the plating operations.

The additive printed wiring boards had two limitations due to the low bond strength of the adhesives at high temperature: failure by blistering and delamination during soldering of multilayer boards with large ground shield areas over ground planes; and failure of the bond between the conductive pattern land and the base material during resoldering repair operations.

Multilayer printed wiring boards are commonly provided with internal ground and power planes. These internal planes are frequently solid sheets of copper only interrupted by clearance holes, the perforations required for electrically isolating the through hole pattern of the printed wiring board. These ground and power planes provide power voltage and current and ground connections for the components of the multilayer printed circuit. A second function of the ground and power planes is to provide electromagnetic shielding for the multilayer printed circuit board and reduce the electromagnetic and radio frequency interference. Multiple ground and power planes and additional ground planes or shields on the surface layers with the conductive pattern are not uncommon.

When components are mounted on a multilayer printed wiring board and mass soldered in place at temperatures in the range of 250-290°C, a tremendous thermal shock is applied to insulating layers placed between two copper planes, such as the insulating layer between an internal ground plane and a ground shield on the surface surrounding the conductor pattern. Frequently, delamination will occur and blisters will form between the ground shield on the surface and the internal ground or power plane.

It is an object of this invention to provide bonding compositions suitable for the manufacture of additive printed wiring boards.

It is also an object of this invention to provide a bonding composition that will withstand the thermal shock of soldering when the bonding composition is between two ground planes or shields.

An object of this invention is to provide an bonding composition with improved high temperature bond strength for bonding the conductive pattern of additive printed wiring boards to the base material.

Another object of this invention is to provide additive printed wiring boards that do not delaminate during repair, component replacement and resoldering.

An additional object of this invention is to provide bonding compositions for manufacture of additive printed wiring boards that can be adhesion promoted, and which do not emit or evolve volatile materials below 288°C after post cure.

It is an object of this invention to provide polymeric materials or blends of polymeric materials which are capable of being cured, adhesion promoted after curing, plated with metal, and post cured after plating to drive off volatiles such as absorbed moisture; and which materials or blends, after post cure, do not evolve volatiles below 288°C.

Another object of this invention is to provide a method of manufacturing full-additive printed wiring boards using, as a bonding layer between the conductive pattern and base material, polymeric materials or blends of polymeric materials which after cure do not evolve volatiles below 288°C.

Yet another object of this invention is to provide a method of manufacturing printed wiring boards by the semi-additive process using, as a bonding layer between the conductive pattern and the base material, polymeric materials or blends of polymeric materials which after cure do not evolve volatiles below 288°C.

As used herein, the term phenolic resin means a polymer formed by the condensation reaction of an aldehyde and a phenol such as unsubstituted phenols and substituted phenols including cresols, xylenols and resorcinol.

The term post cure means the heating or baking step customarily carried out in fully-additive and semi-additive processes after metallization.

The invention comprises a bonding composition for the manufacture of fully-or semi-additive printed wiring boards capable of being applied onto a printed wiring base material and cured to a solid thermoset composition and, when cured, capable of being adhesion promoted for adherent metal deposition thereon, characterized in that the said bonding composition comprises

- a phenolic resin being substantially free of methyl ether groups and having an average of between 4 and 10 phenolic rings per molecule and at least two methylol functional groups;
- at least one heat resistant polymer having an aromatic or cyclic backbone and functional groups capable of crosslinking with phenolic methylol groups without evolving water, said heat resistant polymer(s) being present in an amount sufficient to react with sub-stantially all the methylol groups of the phenolic resin, said polymer with aromatic or cyclic backbones being capable of improving the electrical or heat resistant properties of said bonding composition: and
- an elastomer selected from the group consisting of neoprene, nitrile rubber and chlorosulfonated polyethylene, and vinyl and acrylic elastomers, said elastomer being 30 to 60% of the combined weight of the phenolic and heat resistant resins and elastomer; and that the bond of a metal layer deposited on said cured, wettable and microporous bonding composition is maintained for at least 10 seconds at a temperature of 430°C.

There is also provided an additive printed wiring board capable of withstanding soldering cycles of at least 255°C and repair and component replacement temperatures of at least 430°C for at least 10 seconds without delamination or blistering. The board is comprised of an organic insulating basematerial with a metallic conductive pattern securely adhered thereto with the bonding composition as described hereinbefore. The peel strength is at least 2 N/mm.

In another embodiment, the invention comprises an improved method of manufacturing a fully-additive printed wiring board wherein an organic insulating base material is coated with a phenolic resin-elastomer adhesive layer, the adhesive layer is cured, adhesion promoted and a metallic conductove pattern plated thereo. The improvement comprises employing as the adhesive layer the bonding composition as described hereinbefore.

In still another aspect, this invention comprises an improved method of manufacturing a semiadditive printed wiring board comprising the steps of coating an organic insulating base material with a phenolic resin-elastomer adhesive layer, curing the adhesive layer and adhesion promoting it, plating a metallic layer thereon, imposing a resist image on the metallic layer, plating a metallic conductive pattern on the resist image, and removing the resist image and that portion of the metallic layer not covered by the conductive pattern stripped, thereby producing a semi-additive printed wiring board capable of withstanding soldering cycles of at least 255°C and repair and component replacement temperatures of at least 430°C for at least 10 seconds without delamination or blistering. The improvement comprises employing as the adhesive layer the bonding composition as described hereinbefore.

This invention concerns bonding compositions suitable for bonding conductive patterns to base

materials in the manufacture of printed wiring boards by additive processes. The bonding compositions also are useful in the lamination of copper foil to printed wiring base materials for use in manufacturing printed wiring boards by subtractive processes.

The bonding compositions used in the prior art required careful control of temperature during repair operations to avoid bond failures at the point of repair. Also multilayer printed wiring boards prepared by the additive process required special, restrictive, design rules limiting the size of ground shields, avoiding placement of two ground shields one over the other, and requiring cross hatching or open areas in a ground shield. These design rules were required to prevent delamination during mass soldering operations such as hot air solder leveling, wave soldering, infra-red solder reflow or vapor phase soldering.

The thermal stress of soldering is especially severe in repair operations where a defective component is unsoldered and removed from a printed circuit board. In repair operations, temperatures at the soldering tip range from 400 -500°C. In the case of multilayer printed wiring boards where the bonding layer is sandwiched between two ground planes or ground shields, thermal stress is severe at soldering temperatures as low as 230 - 290°C. Suprisingly, even though the bonding layer is fully cured and post cured after metallization, applicant has discovered that these bond failures and the delamination are caused by the evolution of volatile materials from the bonding layer during the thermal stress of soldering. This invention teaches methods of selecting materials and formulating bonding compositions to avoid the evolution of volatile compounds at elevated temperatures.

The preferred materials for the bonding a conductive metallic pattern to organic insulating base materials for additive printed wiring boards are polymer blends containing elastomers, phenol-formaldehyde (phenolic) resins resins with excellent electrical properties and high temperature resistance which are added to the polymer blend to improve these properties. Resins with aromatic or cyclic backbones contribute excellent electrical and high temperature properties. Especially suitable are epoxy and triazine resins and combinations of epoxy and triazene resins.

The classification of phenolic resins includes not only the reaction product of phenol and formaldehyde, but also the reaction of formaldehyde and other low molecular weight aldehydes with substituted phenols, cresols, xylenols, resorcinols and naphthanols. Phenols can be reacted with aldehydes to produce polymer resins using either acidic or alkaline conditions.

Reaction of phenols and formaldehyde under acidic conditions produces the "novolac" polymers.

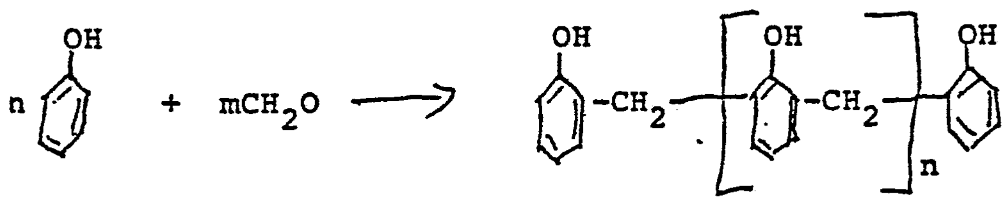

Novolacs are characterized by linear molecules without side chains. They are frequently crosslinked by the addition of hexamethylene tetramine. In the crosslinking reaction, hexamethylene generates formaldehyde and liberates ammonia; the crosslinking reaction also eliminates water. Since it evolves volatile products, the hexamethylene tetramine curing mechanism is not suitable for this invention.

Reactions of phenols and formaldehyde under alkaline conditions produce branched polymers known as resoles.

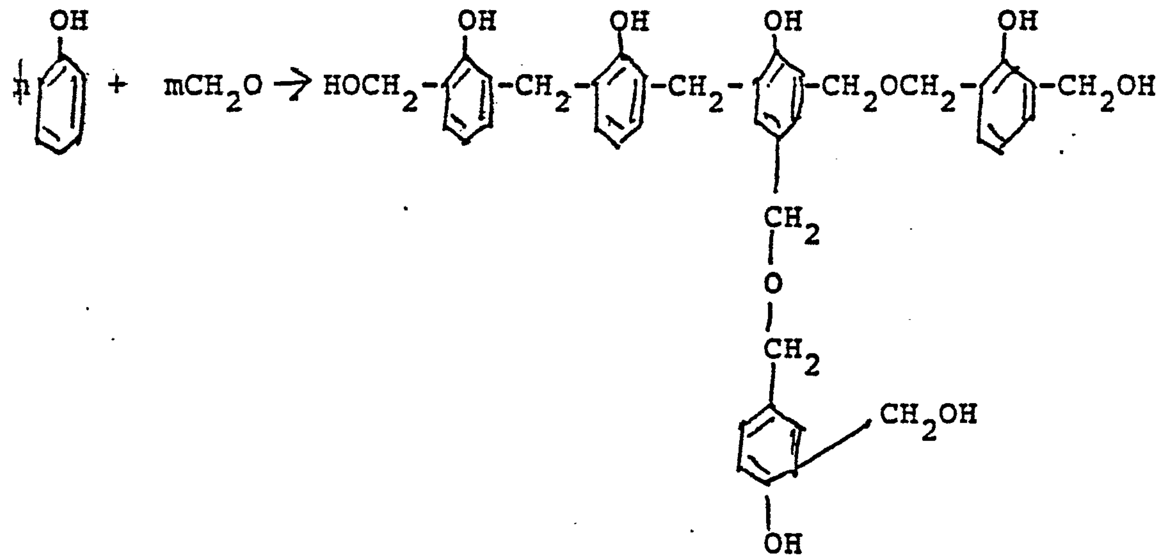

The bridges between phenol nuclei in resoles are mainly methylene groups, although some methyl ether groups may still be present depending on the degree of cure. Resoles crosslink into infusible solids by the action of heat. During heat curing, the methylol groups crosslink with the neighboring chains and evolve water. This evolution of water generally takes place at temperatures as low as 110 - 130°C. The remaining methyl ether linkages between the phenolic rings condense to methylene linkages with the evolution of formaldehyde at more elevated temperatures in the range of 145 - 180°C.

In the sequence of manufacturing an additive printed wiring board utilizing a phenolic resin/rubber adhesive as the bonding layer, the adhesive is applied to the basis material, dried and cured at temperatures between 130 and 160°C. The cured adhesive layer is adhesion promoted to provide a suitable base for electrolessly depositing the conductive pattern.

It has been found that the bonding compositions of this invention are easily adhesion promoted, and that the adhesion promotion process is repeatable and reliable. It is believed that the facile, repeatable and reliable adhesion promotion is due to the combination of a phenolic resin with an elastomer and a heat resistant polymer. The combination of an elastomer with a heat resistant polymer without phenolic resin is more difficult to adhesion promote and it is difficult to achieve repeatable and reliable bonds.

After plating the conductive pattern, the board is post cured, again at temperatures of 130-160°C. The post cure is believed to relieve the stresses formed in the electroless deposition of metal on the organic substrate and remove absorbed moisture from the substrate.

It has been now found that temperatures of this process, while sufficient to initiate vulcanization of the rubber and crosslinking between phenolic chains through terminal methylol groups, did not accomplish the conversion of residual methyl ether groups and prevent the later evolution of formaldehyde at the higher temperatures of soldering and component repair.

In carrying out metallizing processes of this invention using bonding layers containing resoles, it is preferred to use resoles having substantially no methyl ether linkages between phenolic rings. When such is the case, any water formed will evolve during the curing of the bonding composition before metallization; and the water can escape from the system. If the resole contains a large number of methyl ether groups, the evolution of the formaldehyde will take place, not at the curing before metallization, but rather at soldering temperatures which are reached after metallization. The evolving formaldehyde will cause blistering and delamination since the metal layer is impervious and does not allow the escape of the formaldehyde from the system.

It now has been found that improved high temperature bond strength and resistance to bond failures of additive printed wiring boards and additive multilayer printed wiring boards can be achieved by formulating a bonding layer that cures without evolution of compounds that volatilize below 288°C. For elastomer/phenolic resin systems, this can be accomplished by selecting either novolac resins which are essentially free of methyl ether and methylol groups which generate volatile water and formaldehyde reaction products during cure or subsequent heat exposure, or resole resins which are substantially free of methyl ether groups. If resole phenolic resins are used in the elastomer/resin blend according to this invention, the phenolic resin should be crosslinked by (1) reacting the methylol groups of the phenolic resin with crosslinking agents in reactions that do not evolve water; and (2) usisng substantially straight chain

phenolic resins with a minimum of branching.

Epoxy resins are among the curing agents suitable for crosslinking phenolic resins without the evolution of water. Epoxy resins can react with the methylol groups without the evolution of water as follows:

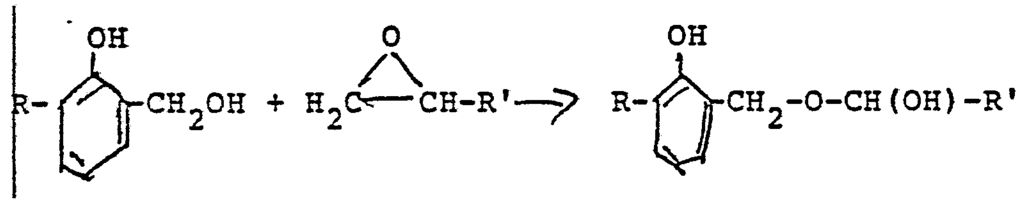

Epoxy resins also can crosslink with the phenolic hydroxide group of both novolac and resole resins.

Phenolic resins with a minimum of branching are preferred, the more highly branched resole resins have more terminal methylol groups. In a highly branched resole resin, this large number of methylol groups may be blocked from completely reacting with the curing agent, e.g., by the immobility imposed as the crosslinking reaction continues. It now has been found that highly branched phenolic resins in the bonding layer lead to blistering of ground shields and poor adhesion at high temperatures. It is assumed that unreacted methylol groups condense at elevated temperatures releasing water and formaldehyde.

Suitable phenolic resins with a minimum of branching are novolacs and resoles based on phenols substituted in the ortho or para position, e.g., o-cresol or p-cresol also have minimum branching. Resole resins based on phenols substituted in both the ortho and meta or meta and para positions also are suitable for the practice of this invention, e.g., resins based on 2,3-dimethylphenol, 3,4-dimethylphenol or 2,5-dimethyl phenol. Resins incorporating phenols with the highly alkyl subsitution may also be used.

The preferred phenolic resin for use in this invention will have a degree of polymerization from about an average of 4 phenolic rings to an average of about 10 phenolic rings per molecule. Some of the resin molecules have a degree of polymerization and above the average and some will be below. For example, a phenolic resin with an average degree of polymerization of 5 may contain molecules with degrees of poymerization ranging from 1 to 11.

Suitable elastomers are synthetic and natural rubbers including neoprene, nitrile rubber and chlorosulfonated polyethylene, and vinyl and acrylic elastomers. The amount of elastomer incorporated in the polymer blend is 30-60% of the total weight of polymers.

The preferred rubber is a nitrile rubber, a copolymer of butadiene and acrylonitrile. Other rubbers may be used and blends of rubbers are more preferred than a single rubber. Chlorosulfonated polyethylene rubbers may be blended with nitrile rubbers for improved bond strength at soldering temperatures.

Nitrile rubbers are copolymers of acrylonitrile and butadiene. The rubbers formed by the copolymerization contain a double bond and crosslink by reactions involving the double bond. Other rubbers capable of crosslinking by reactions involving double bonds may be substituted for nitrile rubbers in the adhesives.

The preferred vinyl or acrylic elastomer is polyvinyl butyral.

Polyvinyl butyral resins are prepared by the reaction of butyraldehdye with polyvinyl alcohol. Polyvinyl butyral resins contain some vinyl alcohol and vinyl acetate groups in addition to the vinyl butyral groups.

The heat resistant polymers used in this invention have aromatic or cyclic backbones. Suitable polymers contain functional groups capable of crosslinking with the phenolic resin. When resole phenolic resins are used, the functional groups should be capable of reacting with the methylol groups of phenolic resole resins without evolving water. The heat resistant polymers also should have good electrical insulating properties in order to improve electrical and heat resistant properties of the phenolic-elastomer compsition. Among suitable heat resistant resins are bismaleimide-triazine resins and epoxy resins with epoxy equivalent weights of about 170 to about 2500 and an epoxide functionality between 1.5 and 3. Suitable epoxy resins are bisphenol A epoxy resins and cyclic aliphatic epoxy resins.

The epoxy resin for use in this invention is preferably a solid resin. The ratio of epoxy resin to phenolic resin should be sufficient to provide enough epoxide groups to crosslink with the methylol groups present in the phenolic resin in order to avoid the elimination of water, methanol or formaldehyde from the cured bonding layer.

The ratio of epoxy resin to phenolic resole resin can be determined by the epoxy equivalent weight of the epoxy resin and the average equivalent weight of methylol functional groups in the phenolic resin.

The optimum ratio of epoxy and phenolic resins also can be determined by varying the ratio of the components in the adhesive formulation. This method has the advantage of allowing for the phenolic resin used to vulcanize the rubber and for the epoxy reaction with the phenolic hydroxyl group. In another procedure, the evolution of volatile components from the bonding layer during cure temperatures (130-160°C), at mass soldering temperatures (250°C) and at circuit board repair temperatures (430°C) is followed by thermogravimetric measurements. The optimum ratio of epoxy resin to phenolic resin is determined as the ratio with the lowest loss of volatile materials during the thermogravimetric measurements.

Reinforcing fillers also are included in the bonding layer to improve toughness and performance. Fillers for rubbers and adhesives are well known. Alumina, clays, zirconium silicate and silica are among the most useful. The fillers selected should not contain absorbed water, and should not react with the adhesive system to evolve water or volatiles during curing or at soldering temperatures.

Coupling agents are incorporated into the bonding composition to couple the fillers, polymer components and the base material. The coupling agents are preferably selected from amine substituted organic zirconates and titanates. These agents are believed to also increase the adhesion between the bonding composition and metal deposits thereon.

Other components of the bonding composition may include catalysts for electroless metal deposition, solvents and flow promoters or debubblers.

The bonding composition may be prepared by dissolving the resins and rubbers in the solvents and adding the fillers. The fillers should be dispersed in the bonding composition by milling or the like. The bonding composition may be applied to the base material as a liquid. The curing cycle of the bonding composition layer should include a heating step sufficient to extract the solvent before the resins and rubbers are cured. Usually 15 minutes at 85 - 95°C is sufficient. The dried layer of bonding composition should be at least 7 micrometers thick and preferably 20-50 micrometers thick.

Alternatively, the bonding composition may be formed into a dry film and applied to the base material by hot roll, vacuum or press lamination.

EXAMPLE 1

An adhesive was prepared with the following formulation:

| | | |
|---|---|---|
| Nitrile rubber | 16.88 | g |
| Chlorosulfonated polyethylene rubber | 5.67 | g |
| Palladium catalyst (1%) dispersed in a liquid epoxy resin with an epoxide equivalent weight of 180 | 3.32 | g |
| Zirconium silicate filler | 11.45 | g |
| Fumed silica | 0.27 | g |
| High flash aromatic naphta, with 82-88% aromatics and a boiling range of 150-200°C | 11.48 | g |
| 2-ethoxyethyl acetate | 28.76 | g |
| 2-methylphenol-formaldehyde resin with an average degree of polymerization of 8 | 6.97 | g |
| Solid diepoxide bisphenol A resin with an epoxide equivalent weight of 500 | 12.03 | g |
| Flow promoter | 0.97 | g |
| Catalytic clay filler cont. 1200 ppm Pd | 1.93 | g |
| Neoalkoxy tris(3-amino)phenyl zirconate | 1.40 | g |

The viscosity of the solution was adjusted to 0.5 Pa.s with 2-ethoxyethyl acetate. The bonding composition was applied by the curtain coating technique to a sheet of epoxy glass (FR-4) base material; a wet film thickness of 0.15 mm was achieved. The solvent was removed from the coated film by hot air drying at 90°C for 15 minutes. Then the coated layer was cured at 160°C for 1 hour. This solvent extraction and curing produced a bonding layer 25 micrometers thick.

The coated base material was lightly abraded to deglaze the surface and imprinted with negative resist which outlined the conductive pattern for a printed wiring board. The conductive pattern was adhesion promoted by immersion in a chromic acid solution containing hexavalent chromium, fluoride and sulfuric acid. After rinsing and neutralizing the residual hexavalent chromium with sulfite, the conductive pattern was electrolessly plated with a 38 micrometer thick copper deposit.

After copper plating, the printed wiring board was post cured at 160°C for one hour. The peel strength of the copper conductive pattern was 2.3 N/mm.

The bond strength at elevated temperatures was tested using a thermostatically controlled soldering iron. The soldering iron was applied to a copper land 6.3 mm in diameter and the high temperature stability of the bond was measured as the time required for the bond to fail, the bonding layer to melt and the land slide away. For comparison, the same test was performed on a standard additive printed wiring board and a standard subtractive printed wiring board. The results were as follows:

| Temperature °C | This Adhesive | Additive Board | Subtractive Board |
|---|---|---|---|
| 260 | 190 sec. | 50 sec. | 60 sec. |
| 315 | 60 | 18 | 25 |
| 370 | 30 | 10 | 15 |
| 430 | 12 | 2 | 6 |

It can be seens that the adhesive bonding layer of this example has superior strength at both the soldering temperature of 260°C and the repair temperature of 430°C compared to the standard additive and subtractive printed wiring boards.

EXAMPLE 2

A bonding layer composition was prepared with the following composition:

| | |
|---|---|
| Phenolic resin | 11.0 g |
| Polyvinyl butyral resin | 15.0 g |
| Diepoxide bisphenol A resin (epoxide equiv. weight 850-975) | 22.0 g |
| Catalytic filler (cont. 1200 ppm Pd) | 4.0 g |
| Neoalkoxy tris(3-amino)phenyl zirconate | 1.4 g |
| Flow promoter | 1.0 g |
| Defoamer | 1.0 g |
| Zirconium silicate filler | 15.0 g |
| 2-(2-butoxyethoxy)ethanol | 20.0 g |

The coating was prepared by first heating together the phenolic resin and the polyvinyl butyral. Then, the phenolic-vinyl butyral systems was mixed with the powdered epoxy and with the solvent. Next, the neoalkoxy tris(3-amino)phenyl zirconate coupling agent was added, and the zirconium silicate and catalytic clay fillers were dispersed into the solution of the resins. The flow promoter and defoamer were added to ensure that the coating as applied was free of "orange peel" and bubbles.

The viscosity was adjusted to 30 Pa.s and the coating was applied to glass reinforced epoxy laminate base material by serigraphy as in Example 1.

The adhesive coated base material was plated with a copper conductive pattern by the procedures of Example 1. The bond strength was 2.5 N/mm, and there was no delamination, or blisters formed after exposure to molten solder at 255°C for 5 cycles of 5 seconds. When tested by pushing with a thermostatically controlled soldering iron, there was no movement or sliding of the conductive pattern lands until after the time interval shown in the Table below:

| Soldering Iron Temperature °C | Elapsed Time Before Land Movement Seconds |
|---|---|
| 260 | 250 |
| 315 | 110 |
| 270 | 30 |
| 430 | 15 |

Example 3

A phenolic-nitrile rubber adhesive formulation is prepared using a bismaleimide-triazine resin as the heat resistant resin:

| | |
|---|---|
| Trifunctional phenolic resin (average of 8 phenol groups per molecule) | 11.2 g |
| Nitrile rubber | 22.4 g |
| Bismaleimide-triazine resin | 22.4 g |
| 2-(2-butoxyethoxy)ethanol | 30.0 g |
| Neoalkoxy tris(3-amino)phenyl zirconate | 1.4 g |
| Zirconium silicate filler | 12.0 g |
| Catalytic clay filler w. 1200 ppm Pd | 4.0 g |
| Defoamer | 1.0 g |
| Flow promoter | 1.0 g |
| Zinc octanoate | 0.015 g |

The phenolic resin, nitrile rubber and the bismaleimidetriazine resin are mixed with half of the 2-(2-butoxyethoxy) ethanol and heated to 60°C to solvate the system. The neoalkoxy tris(3-amino)phenyl zirconate is added to this mixture. Then, the fillers, the flow promoter, the defoamer and the remaining solvent are dispersed into the mixture and the mixture is allowed to cool.

Prior to applying the coating to base material, the zinc octanoate is added and thoroughly mixed. The viscosity is adjusted by the addition of solvent until a suitable viscosity for curtain coating is produced (approximately 0.5-11.0 Pa.s).

The coating is applied to the base material by the curtain coating technique, dried and cured for 120 minutes at 160°C. A resist image is applied and a copper conductive pattern is formed by adhesion promoting the coating and electrolessly plating copper. An excellent bond is formed between the conductive pattern and the coated base material. The bond does not fail during a soldering cycle nor during a simulated component replacement.

Example 4

A bonding composition is formulated containing a phenolic resin, polyvinyl butyral and a bismaleimide-triazine resin. This composition is suitable for coating on base materials for form a substrate for semi-additive printed wiring boards:

| | |
|---|---|
| Phenolic resin | 14.5 g |
| Polyvinyl butyral resin | 14.5 g |
| Bismaleimide-triazine resin | 29.0 g |
| Butyl acetate | 30.0 g |
| Neoalkoxy tris(3-amino)phenyl zirconate | 1.4 g |
| Flow promoter | 1.0 g |
| Defoamer | 1.0 g |
| Zirconium silicate filler | 12.0 g |
| Zinc octanoate | 0.015 g |

The coating is prepared by reacting the phenolic resin with the polyvinyl butyral, and then addidsng the bismaleimide-triazine resin and the butyl acetate solvent. Then the neoalkoxy tris(3-amino) zirconate is added and mixed thoroughly. The defoamer is added followed by the filler and the flow promoter. The zinc octanoate is added just prior to applying the coating.

The coating is applied to an epoxy glass board by curtain coating as described above. It is cured at 150°C for 120 minutes. The holes for plated through holes are drilled in the board, and the board is treated with a chromic acid solution to adhesion promote the coating. After adhesion promoting the coating, the coated based material is immersed in a palladium chloride-tin chloride activating solution to activate the surface for electroless metal plating. The coated base material is electrolessly plated with a layer of copper 2.5 micrometers thick. After a post cure, a resist image is printed on the copper layer and a copper conductive pattern is electroplated on the 2.5 micrometer thick layer of copper. The resist image is stripped from the board exposing the layer of copper in the background around the electroplated conductive pattern. The background layer of copper is etched away, completing the formation of a semi-additive printed wiring board. The conductive pattern has excellent adhesion to the base material, and the bond does not fail when tested at soldering temperatures and with a soldering iron simulating component replacement.

Example 5

Another bonding composition is formulated:

| | |
|---|---|
| Phenolic resin | 8.8 g |
| Polyvinyl butyral resin | 11.8 g |
| Bismaleimide-triazine resin | 29.4 g |
| 2-(2-butoxyethoxy)ethanol | 30.0 g |
| Neoalkoxy tris(3-amino)phenyl zirconate | 1.4 g |
| Zirconium silicate filler | 12.0 g |
| Catalytic clay filler with 1200 ppm palladium | 4.0 g |
| Defoamer | 1.0 g |
| Flow promoter | 1.0 g |
| Zinc octanoate | 0.015 g |

The phenolic resin is reacted with the polyvinyl butyral. The bismaleimide-triazine resin is dissolved in part of the 2-(2-butoxyethoxy)ethanol and the phenolic-polyvinyl butyral mixture is added and dissolved. Then the neoalkoxy tris(3-amino)phenyl zirconate is added, and the fillers are dispersed into the solution along with the defoamer, flow promoter and remainder of the solvent.

Prior to application, the zinc octanoate accelerator is added and the viscosity is adjusted for serigraphic coating. The bonding composition is coated serigraphically on a base material using a 110 mesh nickel coated polyester screen and cured at 160°C for 2 hours. A printed wiring board is formed by an additive process. The bonding composition maintains a strong bond between the conductive pattern and the base material during soldering and repair testing.

## Claims

1. A bonding composition for the manufacture of fully and semi-additive printed wiring boards capable of being applied onto a printed wiring base material and cured to a solid thermoset composition and, when cured, capable of being adhesion promoted for adherent metal deposition thereon, characterized in that the said bonding composition comprises

- a phenolic resin being substantially free of methyl ether groups and having an average of between 4 and 10 phenolic rings per molecule and at least two methylol functional groups;
- at least one heat resistant polymer having an aromatic or cyclic backbone and functional groups capable of crosslinking with phenolic methylol groups without evolving water, said heat resistant polymer(s) being present in an amount sufficient to react with substantially all the methylol groups of the phenolic resin, said polymer with aromatic or cyclic backbones being capable of improving the electrical or heat resistant properties of said bonding composition; and
- an elastomer selected from the group consisting of neoprene, nitrile rubber and chlorosulfonated polyethylene, and vinyl and acrylic elastomers, said elastomer being 30 to 60% of the combined weight of the phenolic and heat resistant resins and elastomer; and that the bond of a metal layer deposited on said cured, wettable and microporous bonding composition is maintained for at least 10 seconds at a temperature of 430°C.

2. The bonding composition of claim 1 wherein the polymer with aromatic or cyclic backbones is selected from the group consisting of cyclic aliphatic epoxy resins and bisphenol A epoxy resins having an average of between 1.5 and 3 epoxide functional groups per molecule and an epoxy equivalent weight between 170 and 2500.

3. The bonding composition of claims 1 and 2, characterized in that the polymer with aromatic or cyclic backbones further includes bismaleimide-triazine poymer resins.

4. The bonding composition of claims 1 to 3, characterized in that it further comprises fillers and coupling agents.

5. The bonding composition of claim 4, characterized in that said coupling agents are selected from the group consisting of amino substituted organic zirconates and titanates.

6. The bonding composition of claim 1, characterized in that it further comprises an agent which makes it catalytic for electroless metal plating thereon.

7. An additive printed wiring board capable of withstanding soldering cycles of at least 255°C and repair and component replacement temperatures of at least 430°C for at least 10 seconds without delamination or blistering, characterized in that it is comprised of an organic insulating base material coated on at least one of its surfaces with a bonding composition prepared in accordance with one or more of claims 1 to 6.

8. A method of manufacturing an additive printed wiring board wherein an organic insulating base material is coated with a phenolic resin-elastomer adesive layer, characterized in that the adhesive layer is a bonding composition prepared in accordance with one or more of claims 1 to 6.

9. A method of manufacturing a semi-additive printed wiring board comprising the steps of coating an organic insulating base material with a phenolic resin-elastomer adhesive layer, curing the adhesive layer and adhesion promoting it, plating a metallic layer thereon, imposing a resist image on the metallic layer, plating a metallic conductive pattern on the resist image, and removing the resist image and that portion of the metallic layer not covered by the conductive pattern stripped, thereby producing a semi-additive printed wiring board capable of withstanding soldering cycles of at least 255°C and repair and component replacement temperatures of at least 430°C for at least 10 seconds without delamination or blistering, characterized in that the said adhesive layer is the bonding composition prepared in accordance with one or more of claims 1 to 6.